# EUROPEAN PATENT APPLICATION

(11) **EP 3 586 943 A1**
(43) Date of publication of application: **01.01.2020**
(21) Application number: 19182896.1
(22) Date of filing: 27.06.2019
(51) Int. Cl.: B01D 53/26, C23C 16/40, F28F 13/18, F28F 17/00

(54) **HYDROPHOBIC SURFACES FOR HEAT EXCHANGERS VIA ATOMIC LAYER DEPOSITION**

(30) Priority: 29.06.2018 US 201816023392
(71) Applicant: Hamilton Sundstrand Corporation, Charlotte, NC 28217-4578 (US)
(72) Inventor: POTEET, Steven, 06518, CT Connecticut Hamden (US); GIULIETTI, Diana, Tariffville, CT Connecticut 06081 (US)
(74) Representative: Dehns

(57) **Abstract**

A method of applying a hydrophobic surface coating (42) to one or more internal surfaces of a fluid passage component (20), the method including: flowing a rare earth precursor into the fluid passage component (20); allowing the rare earth precursor to react with the one or more internal surfaces (38) of the fluid passage component (20); removing excess rare earth precursor from the fluid passage component (20); flowing an oxide forming precursor into the fluid passage component (20); allowing the oxide forming precursor to react with the rare earth precursors on the one or more internal surfaces to form a hydrophobic surface coating (42) on each of the one or more internal surfaces (38); and removing excess oxide forming precursor from the fluid passage component (20).

## Description

### BACKGROUND

The subject matter disclosed herein generally relates to the field of fluid passage components, and more particularly to method and apparatus for reducing moisture in fluid passage components.

In an aircraft air condition system, moisture may condense and build up on air conditioning components. The moisture must be collected and drained from engine bleed air, or compressed ambient air, at a location downstream of a condenser to prevent re-entry into the cabin or air cycle machine where the moisture may cause damage.

### BRIEF SUMMARY

According to one embodiment, a method of applying a hydrophobic surface coating to one or more internal surfaces of a fluid passage component is provided. The method including: flowing a rare earth precursor into the fluid passage component; allowing the rare earth precursor to react with the one or more internal surfaces of the fluid passage component; removing excess rare earth precursor from the fluid passage component; flowing an oxide forming precursor into the fluid passage component; allowing the oxide forming precursor to react with the rare earth precursors on the one or more internal surfaces to form a hydrophobic surface coating on each of the one or more internal surfaces; and removing excess oxide forming precursor from the fluid passage component.

In addition to one or more of the features described above, or as an alternative, further embodiments may include: flowing a rare earth precursor into the fluid passage component; allowing the rare earth precursor to react with the hydrophobic surface coating on each of the one or more internal surfaces of the fluid passage component; removing excess rare earth precursor from the fluid passage component; flowing an oxide forming precursor into the fluid passage component; allowing the oxide forming precursor to react with the rare earth precursors on the one or more internal surfaces to form a second layer of a hydrophobic surface coating on each of the one or more internal surfaces; and removing excess oxide forming precursor from the fluid passage component.

In addition to one or more of the features described above, or as an alternative, further embodiments may include that the rare earth precursor includes at least one of tetrakis(2,2,6,6-tetramethyl-3,5-heptanedionato)cerium, (tris(isopropylcyclopentadienyl)cerium, tris(2,2,6,6,-tetramethyl-3,5-heptanedionato)-1,10-phenanthroline)cerium, and tetrakis(1-methoxy-2-methyl-2-propanolate)cerium.

In addition to one or more of the features described above, or as an alternative, further embodiments may include that the oxide forming precursor includes at least one of water, ozone, and an O2 plasma.

In addition to one or more of the features described above, or as an alternative, further embodiments may include that the rare earth precursor is allowed to react with the one or more internal surfaces of the fluid passage component through vapor deposition.

In addition to one or more of the features described above, or as an alternative, further embodiments may include that the rare earth precursor is allowed to react with the one or more internal surfaces of the fluid passage component through chemical vapor deposition.

In addition to one or more of the features described above, or as an alternative, further embodiments may include that the rare earth precursor is allowed to react with the one or more internal surfaces of the fluid passage component through atomic layer deposition.

According to another embodiment, a fluid passage component having a hydrophobic surface coating on one or more internal surfaces of the fluid passage component formed by the method of claim 1 is provided. The fluid passage component including: an inlet; an outlet opposite the inlet; and an inner surface defining a main flow channel, the main flow channel fluidly connecting the inlet to the outlet, the inner surface is one of the one or more internal surfaces having a hydrophobic surface coating.

In addition to one or more of the features described above, or as an alternative, further embodiments may include the fluid passage component is a heat exchanger.

In addition to one or more of the features described above, or as an alternative, further embodiments may include that the fluid passage component is a heat exchanger of an air-conditioning system.

In addition to one or more of the features described above, or as an alternative, further embodiments may include that the fluid passage component is a heat exchanger of an air-conditioning system of an aircraft.

In addition to one or more of the features described above, or as an alternative, further embodiments may include that the fluid passage component is a condenser.

In addition to one or more of the features described above, or as an alternative, further embodiments may include that the fluid passage component is a condenser of an air-conditioning system.

In addition to one or more of the features described above, or as an alternative, further embodiments may include that the fluid passage component is a condenser of an air-conditioning system of an aircraft.

In addition to one or more of the features described above, or as an alternative, further embodiments may include: a cooling fluid passageway in thermal communication with airflow within the main flow channel, the cooling fluid passageway is one of the one or more internal surfaces having a hydrophobic surface coating.

In addition to one or more of the features described above, or as an alternative, further embodiments may include: a heat-transfer fin in thermal communication with airflow within the main flow channel, the heat-transfer fin is one of the one or more internal surfaces having a hydrophobic surface coating.

In addition to one or more of the features described above, or as an alternative, further embodiments may include that the hydrophobic surface coating includes at least one of cerium oxide, erbium oxide, and praseodymium oxide.

According to another embodiment, a fluid passage component is provided. The fluid passage component including: one or more internal surfaces having a hydrophobic surface coating on the one or more internal surfaces, the hydrophobic surface having an oxidized precursor layer bonded to a rare earth precursor layer.

In addition to one or more of the features described above, or as an alternative, further embodiments may include an inlet; an outlet opposite the inlet; and an inner surface defining a main flow channel, the main flow channel fluidly connecting the inlet to the outlet, wherein the inner surface is one of the one or more internal surfaces having a hydrophobic surface coating.

In addition to one or more of the features described above, or as an alternative, further embodiments may include that the fluid passage component is a heat exchanger.

Technical effects of embodiments of the present disclosure include adding a hydrophobic surface to a fluid passage component using atomic layer deposition.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION

The following descriptions should not be considered limiting in any way. With reference to the accompanying drawings, like elements are numbered alike:
FIG. 1 is a schematic representation of airflow progression through an air conditioning system, according to an embodiment of the present disclosure;
FIG. 2 is a cross-sectional view of a fluid passage component of the air conditioning system of FIG. 1, according to an embodiment of the present disclosure;
FIG. 2a is a cross-sectional view of a heat exchanger core, according to an embodiment of the present disclosure;
FIG. 2b is a cross-sectional view of a heat exchanger core, according to an embodiment of the present disclosure; and
FIG. 3 is diagram of a method of adding a hydrophobic surface coating to the fluid passage component of FIG. 2 using atomic layer deposition, according to an embodiment of the present disclosure.

### DETAILED DESCRIPTION

A detailed description of one or more embodiments of the disclosed apparatus and method are presented herein by way of exemplification and not limitation with reference to the Figures.

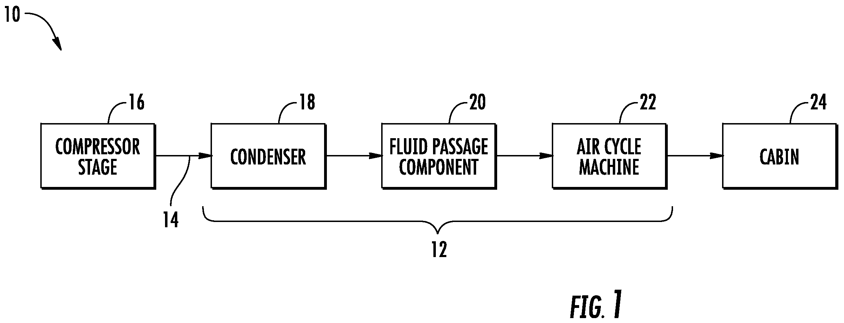

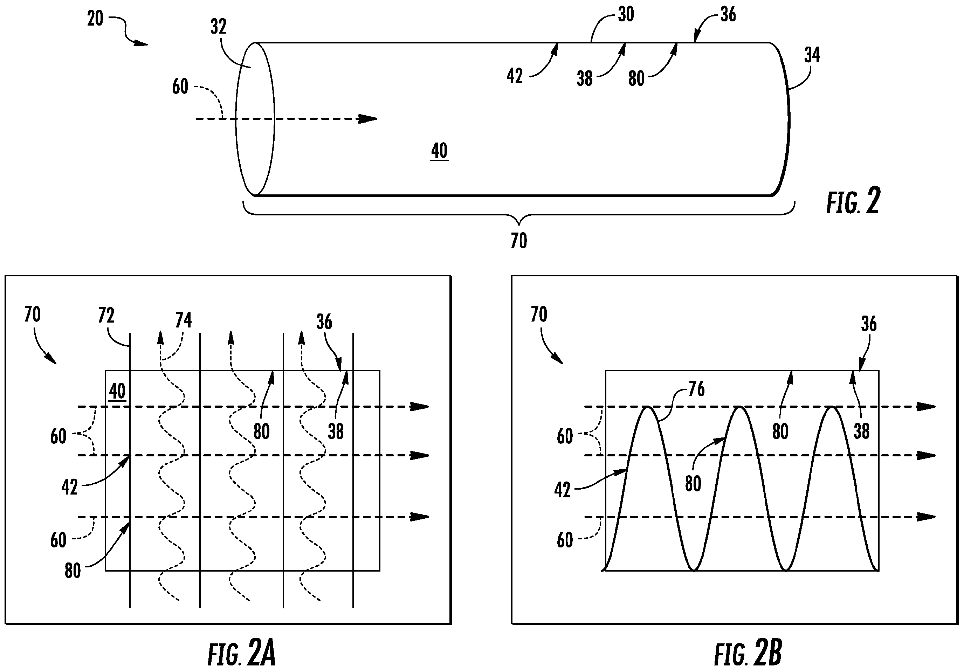

FIG. 1 is a schematic representation of airflow progression 10 through an air conditioning system 12 of an aircraft. It is understood that the air conditioning system 10 is utilized for exemplary purposes and the embodiments disclosed herein may be applied to other systems other than an air conditioning system 12 of an aircraft. The airflow progression 10 is a representation of bleed air 14 as it passes from a compressor stage 16, to an air conditioning system 12 (which includes condenser 18, fluid passage component 20, and air cycle machine 22), and onto a cabin 24. FIG. 1 is a simplified schematic representation of the system, highlighting the moisture extraction portion. All elements up stream of the condenser 18 and downstream of the fluid passage component 20 are not depicted. It should be appreciated that, although particular systems in FIG. 1 are separately defined in the schematic block diagrams, each or any of the systems may be otherwise combined or separated via hardware and/or software. For example, the fluid passage component 20 may be a part of at least one of the compressor stage 16, the condenser 18, the air cycler machine 22, and the cabin 24. In an embodiment, the fluid passage component 20 may have internal surfaces 80 (see FIG. 2, 2a, and 2b) defining internal fluid passageways. The internal surfaces 80 may have complex geometries. In an embodiment, the fluid passage component 20 may be a heat exchanger.

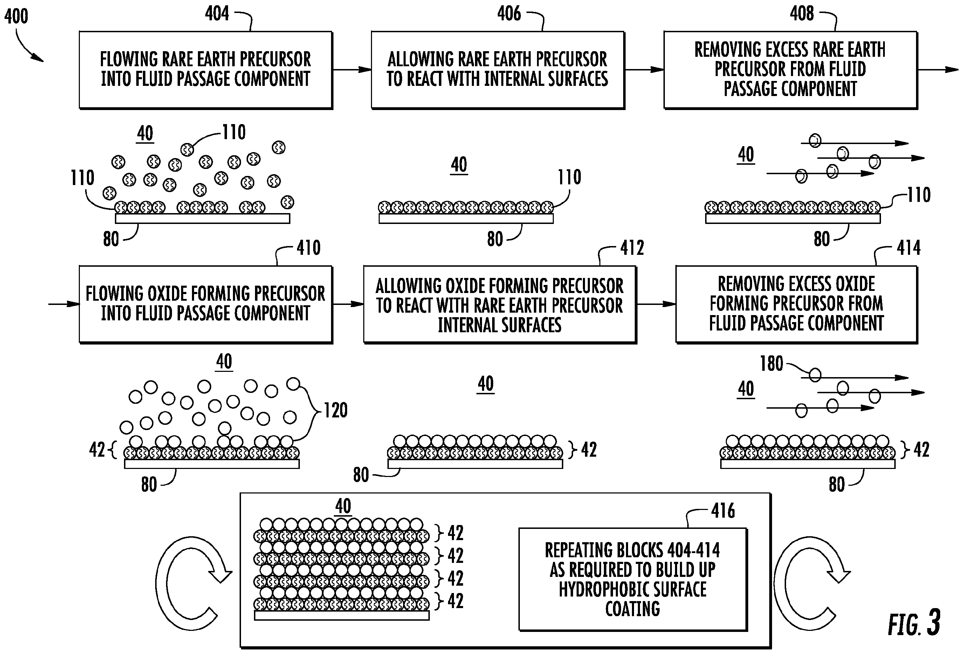

The air conditioning system 12, is a sub-system of an aircraft engine that conditions bleed air 14 so that bleed air 14 can be re-used to perform an additional function within the aircraft. The bleed air 14 is taken from a compressor stage 16 of the aircraft engine. In another non-limiting embodiment, the bleed air 14 can be compressed air taken from an ambient environment. The compressor stage 16 is an intermediate or high pressure stage within the aircraft engine. The condenser 18 is a heat exchanger for condensing moisture into droplets. In an embodiment, the fluid passage component 20 is the condenser 18 of the air conditioning system 12. The fluid passage component 20 includes a main flow channel 40 defined by an internal surface 38 of fluid passage component (see FIG. 2). The internal surface 28 is coated with hydrophobic coating via method 400 discussed below in FIG. 3. The air cycle machine 22 is a component of the air conditioning system 12 for controlling the temperature and pressure of bleed air 14 exiting from the air cycle machine 22 and into cabin 24. The cabin 24 is a compartment of the aircraft for housing passengers and equipment.

The compressor stage 16 is fluidly connected to the condenser 18 via fluid lines or conduits in the aircraft. The condenser may be fluidly connected to the fluid passage component 20. The fluid passage component 20 may be fluidly connected to the air cycle machine 22, and the air cycle machine 22 is fluidly connected to the cabin 24.

During operation of the aircraft engine, bleed air 14 is drawn from the compressor stage 16 and into the condenser 18 of the air conditioning system 12. The condenser 18 condenses moisture in the bleed air 14 from vapor into moisture droplets. In some non-limiting embodiments, bleed air 14 can be conditioned by a heat exchanger in order to increase or decrease the temperature of the bleed air 14 exiting from the condenser 18. The bleed air 14, with the condensed moisture droplets, is then transported to the air cycle machine 22. The air cycle machine 22 further conditions the bleed air 14 by altering the temperature and the pressure of the bleed air 14 to a level appropriate from the passengers in the cabin 24. A more detailed example of an aircraft air conditioning system and/or an environment control system can be found in United States Pat. No. 8,347,647B2.

FIG. 2 is a cross-sectional view of fluid passage component 20, according to an embodiment of the present disclosure. The fluid passage component 20 includes a body 30, an inlet 32, an outlet 34 opposite the inlet 32, an outer surface 36, an inner surface 38, and a main flow channel 40. The inner surface 38 defines the main flow channel 40, which fluidly connects the inlet 32 to the outlet 34.

The fluid passage component 20 also includes a hydrophobic surface coating 42. In an embodiment, all internal surface 80 of the fluid passage component 20 may be coated with the hydrophobic surface coating 42. In another embodiment, the hydrophobic surface coating 42 is located on selected surfaces within the main flow channel 40 of the fluid passage component 20. In an embodiment, the hydrophobic surface coating 42 is located on the inner surface 38 of the main flow channel 40.

The hydrophobic surface coating 42 is configured to repel moisture away from the hydrophobic surface coating 42. The hydrophobic surface coating 42 may be composed of a hydrophobic compound including but not limited to rare earth oxides and phosphates (e.g., CeO₂) that are naturally hydrophobic due to electron shielding of the unoccupied 4f orbitals. Rare earth oxides may include but are not limited to cerium oxide, erbium oxide, praseodymium oxide, or any rare earth oxide known to one of skill in the art. In an embodiment, the hydrophobic surface coating 42 includes at least one of cerium oxide, erbium oxide, and praseodymium oxide.

As mentioned above, the fluid passage component 20 may be a heat exchanger. Advantageously, since the hydrophobic surface coating 42 is configured to repel moisture away from the hydrophobic surface coating 42, the hydrophobic surface coating 42 would be ideal for coating interior surfaces 80 of a heat exchanger core 70 since the heat exchanger core 70 may drop the temperature of airflow 60, thus creating condensation from moisture in the airflow 60. In an embodiment, where the fluid passage component 20 is a heat exchanger, the fluid passage component 20 may include a heat exchanger core 70 located within the fluid passage component 20. The heat exchanger core 70 may designed in various configuration including a non-mixing shell and tube heat exchanger shown in FIG. 2a and a fin type heat exchanger shown in FIG. 2b. It is understood that the heat exchangers cores 70 shown in FIGs. 2a and 2b are exemplary and the embodiments disclosed herein may be applied to any other types of heat exchanger cores 70.

As shown in FIG. 2a, the heat exchanger core 70 may be that of a non-mixing shell and tube heat exchanger. The heat exchanger core 70 allows hot airflow 60 to be in thermal communication with cold airflow 74 in cooling passageways 72 within the main flow channel 40. The cooling passageways 72 physically separates the cold airflow 74 from the warm airflow 60, such that the cold airflow 70 does not mix with the warm airflow 60. The hydrophobic surface coating 42 may coat all internal surfaces 80 of the heat exchanger core 70 including the cooling passageways 72 exposed to the hot airflow 60.

As shown in FIG. 2b, the heat exchanger core 70 may be that of fin type heat exchanger. The heat exchanger core 70 of FIG. 2b includes heat-transfer fins 76 that project out into the hot airflow 60 in the main flow channel 40 and absorb heat from hot airflow 60. The heat absorbed by the heat-transfer fins 76 is then transferred outside of the core 70. The hydrophobic surface coating 42 may coat all internal surfaces 80 of the heat exchanger core 70 including the heat-transfer fins 76 exposed to the hot airflow 60.

Referring now to FIG. 3, with continued reference to FIGs. 1-2, a method 400 includes applying a hydrophobic surface coating 42 to one or more internal surfaces 80 of a fluid passage component 20, using vapor depositions, such as chemical vapor deposition or atomic layer deposition. In an embodiment, at block 404, a rare earth precursor 110 is flowed into the fluid passage component 20. Specifically the rare earth precursor 110 may be flowed into the main flow channel 40 of the fluid passage component 20. At block 406, the rare earth precursor 110 is allowed to react with the one or more internal surfaces 80 of the fluid passage component 20. The rare earth precursor may be tetrakis(2,2,6,6-tetramethyl-3,5-heptanedionato)cerium, (tris(isopropylcyclopentadienyl)cerium, tris(2,2,6,6,-tetramethyl-3,5-heptanedionato)-1,10-phenanthroline)cerium, or tetrakis(1-methoxy-2-methyl-2-propanolate)cerium. In an embodiment, the rare earth precursor includes at least one of tetrakis(2,2,6,6-tetramethyl-3,5-heptanedionato)cerium, (tris(isopropylcyclopentadienyl)cerium, tris(2,2,6,6,-tetramethyl-3,5-heptanedionato)-1,10-phenanthroline)cerium, and tetrakis(1-methoxy-2-methyl-2-propanolate)cerium. The internal surface 80 may be the inner surface 38 of the main flow channel 40, the cooling passageways 72, and/or the heat-transfer fins 76. At block 408, excess rare earth precursor 110 is removed from the fluid passage component 20. For example, the excess rare earth precursor 110 may be removed from the main flow channel 40 by vacuuming the excess rare earth precursor 110 out of the main flow channel 40.

At block 410, an oxide forming precursor 120 is flowed into the fluid passage component 20. Specifically the oxide forming precursor 120 may be flowed into the main flow channel 40 of the fluid passage component 20. At block 412, the oxide forming precursor 120 is allowed to react with the rare earth precursors 110 on the one or more internal surfaces 80 to form a hydrophobic surface coating 42 on each of the one or more internal surfaces 80. The rare earth precursor may be water, ozone, or an O₂ plasma. In an embodiment, the rare earth precursor includes at least one of water, ozone, and an O₂ plasma. At block 414, the excess oxide forming precursor 120 is removed from the fluid passage component 20. For example, the excess oxide forming precursor 120 may be removed from the main flow channel 40 by vacuuming the excess oxide forming precursor 120 out of the main flow channel 40.

The method 400 may be repeated at block 416 to add more than one layer of hydrophobic surface coating 42 on each of the one or more internal surfaces 80. Upon adding a second layer of hydrophobic surface coating 42 at block 406 the rare earth precursor 110 will react with the previous layer of hydrophobic surface coating 42 on each of the one or more internal surfaces 80 rather than the internal surface 80, as described above when laying down the first layer of hydrophobic surface coating 42. The method 400 may be repeated multiple times at block 416 until a desired thickness of the hydrophobic surface coating 42 is obtained on each of the one or more internal surfaces 80. For example, a desired thickness may be 5-10 nm.

While the above description has described the flow process of FIG. 3 in a particular order, it should be appreciated that unless otherwise specifically required in the attached claims that the ordering of the steps may be varied.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims,

## Claims

1. A method of applying a hydrophobic surface coating (42) to one or more internal surfaces (38) of a fluid passage component (20), the method comprising:
flowing a rare earth precursor into the fluid passage component (20);
allowing the rare earth precursor to react with the one or more internal surfaces (38) of the fluid passage component (20);
removing excess rare earth precursor from the fluid passage component (20);
flowing an oxide forming precursor into the fluid passage component (20);
allowing the oxide forming precursor to react with the rare earth precursors on the one or more internal surfaces to form a hydrophobic surface coating (42) on each of the one or more internal surfaces (38); and
removing excess oxide forming precursor from the fluid passage component (20).

2. The method of claim 1, further comprising:
flowing a rare earth precursor into the fluid passage component (20);
allowing the rare earth precursor to react with the hydrophobic surface coating (42) on each of the one or more internal surfaces (38) of the fluid passage component (20);
removing excess rare earth precursor from the fluid passage component (20);
flowing an oxide forming precursor into the fluid passage component (20);
allowing the oxide forming precursor to react with the rare earth precursors on the one or more internal surfaces to form a second layer of a hydrophobic surface coating (42) on each of the one or more internal surfaces (38); and
removing excess oxide forming precursor from the fluid passage component (20).

3. The method of claim 1 or 2, wherein the rare earth precursor includes at least one of tetrakis(2,2,6,6-tetramethyl-3,5-heptanedionato)cerium, (tris(isopropylcyclopentadienyl)cerium, tris(2,2,6,6,-tetramethyl-3,5-heptanedionato)-1,1 0-phenanthroline)cerium, and tetrakis(1 -methoxy-2-methyl-2-propanolate)cerium.

4. The method of claim 1, 2 or 3, wherein the oxide forming precursor includes at least one of water, ozone, and an O₂ plasma.

5. The method of any preceding claim, wherein the rare earth precursor is allowed to react with the one or more internal surfaces of the fluid passage component (20) through vapor deposition, or wherein the rare earth precursor is allowed to react with the one or more internal surfaces of the fluid passage component (20) through chemical vapor deposition, or wherein the rare earth precursor is allowed to react with the one or more internal surfaces of the fluid passage component (20) through atomic layer deposition.

6. A fluid passage component (20) having a hydrophobic surface coating (42) on one or more internal surfaces of the fluid passage component (20) formed by the method of claim 1, the fluid passage component comprising:
an inlet (32);
an outlet (34) opposite the inlet (32); and
an inner surface (38) defining a main flow channel (40), the main flow channel (40) fluidly connecting the inlet (32) to the outlet (34), wherein the inner surface (38) is one of the one or more internal surfaces having a hydrophobic surface coating.

7. The fluid passage component of claim 6, wherein the fluid passage component (20) is a heat exchanger.

8. The fluid passage component of claim 6, wherein the fluid passage component (20) is a heat exchanger of an air-conditioning system, and optionally wherein the fluid passage component (20) is a heat exchanger of an air-conditioning system of an aircraft.

9. The fluid passage component of claim 6, wherein the fluid passage component (20) is a condenser, and optionally wherein the fluid passage component (20) is a condenser of an air-conditioning system, and optionally wherein the fluid passage component (20) is a condenser of an air-conditioning system of an aircraft.

10. The fluid passage component (20) of claim 7, further comprising:
a cooling fluid passageway (72) in thermal communication with airflow within the main flow channel (40), wherein the cooling fluid passageway (72) is one of the one or more internal surfaces having a hydrophobic surface coating (42).

11. The fluid passage component of claim 7, further comprising:
a heat-transfer fin in thermal communication with airflow within the main flow channel (40), wherein the heat-transfer fin is one of the one or more internal surfaces having a hydrophobic surface coating (42).

12. The fluid passage component of claim 7, wherein the hydrophobic surface coating includes at least one of cerium oxide, erbium oxide, and praseodymium oxide.

13. A fluid passage component, comprising:
one or more internal surfaces having a hydrophobic surface coating (42) on the one or more internal surfaces, the hydrophobic surface having an oxidized precursor layer bonded to a rare earth precursor layer.

14. The fluid passage component (20) of claim 13, further comprising
an inlet (32);
an outlet (34) opposite the inlet (32); and
an inner surface (38) defining a main flow channel (40), the main flow channel (40) fluidly connecting the inlet to the outlet (34), wherein the inner surface (38) is one of the one or more internal surfaces having a hydrophobic surface coating (42).

15. The fluid passage component of claim 6 or 14, wherein the fluid passage component (20) is a heat exchanger.
